# FASCICULE DE BREVET EUROPEEN

(11) **EP 3 250 725 B1**
(45) Date de publication et mention de la délivrance du brevet: **18.09.2019**
(21) Numéro de dépôt: 16704479.1
(22) Date de dépôt: 01.02.2016
(51) Int. Cl.: C23C 2/06, C23C 2/26, C23C 22/05, C23C 22/78, C23C 22/82, C23F 11/14, C25D 5/48, C23C 22/53, C23C 22/68

(54) **PROCÉDÉ DE PRÉPARATION D'UNE TÔLE REVÊTUE COMPRENANT L'APPLICATION D'UNE SOLUTION AQUEUSE COMPRENANT UN AMINOACIDE ET UTILISATION ASSOCIÉE POUR AMÉLIORER LES PROPRIÉTÉS TRIBOLOGIQUES**
VERFAHREN ZUR HERSTELLUNG EINES BESCHICHTETEN METALLBLECHS UNTER ANWENDUNG EINER WÄSSRIGEN, AMINOSÄUREHALTIGEN LÖSUNG UND VERWENDUNG DAVON ZUR VERBESSERUNG DER TRIBOLOGISCHEN EIGENSCHAFTEN
METHOD FOR THE PRODUCTION OF A COATED METAL SHEET, COMPRISING THE APPLICATION OF AN AQUEOUS SOLUTION CONTAINING AN AMINO ACID, AND ASSOCIATED USE IN ORDER TO IMPROVE TRIBOLOGICAL PROPERTIES

(30) Priorité: 30.01.2015 WO PCT/IB2015/050725
(43) Date de publication de la demande: 06.12.2017
(73) Titulaire: Arcelormittal S.A., 1160 Luxembourg (LU)
(72) Inventeur: RACHIELE, Lydia, 57120 Rombas (FR); DERULE, Hervé, 57645 Montoy Flanville (FR); THAÏ, Delphine, 57310 Bousse (FR)
(74) Mandataire: Lavoix
(86) Numéro de dépôt international: PCT/IB2016/050504
(87) Numéro de publication internationale: WO 2016/120854

(56) Documents cités:
- EP-A1- 2 458 031
- EP-A2- 2 241 654
- JP-A- 2007 284 710
- US-A1- 2014 360 630
- US-B1- 6 432 220

## Description

La présente invention est relative à une tôle comprenant un substrat en acier présentant deux faces dont au moins l'une est revêtue par un revêtement métallique comprenant au moins 40% en poids de zinc, à son procédé de préparation et à l'utilisation d'un aminoacide pour améliorer les propriétés tribologiques de tôles revêtues de revêtements à base de zinc.

Ces tôles en acier revêtues sont par exemple destinées au domaine de l'automobile. Les revêtements métalliques comprenant essentiellement du zinc sont traditionnellement utilisés pour leur bonne protection contre la corrosion.

Avant d'être utilisées, les tôles en acier revêtues sont généralement soumises à divers traitements de surface.

La demande US 2010/0261024 décrit l'application d'une solution aqueuse de glycine ou d'acide glutamique sous forme neutre ou de sel sur une tôle en acier recouverte d'un revêtement à base de zinc pour améliorer la résistance à la corrosion de la tôle.

La demande WO 2008/076684 décrit l'application sur une tôle en acier revêtue de zinc, sur une tôle en acier électrozinguée ou sur une tôle en acier galvanisée d'une composition de prétraitement consistant en une solution aqueuse comprenant un composé comprenant un métal du groupe IIIB (Sc, Y, La, Ac) ou du groupe IVB (Ti, Zr, Hf, Rf) et un composé à base de cuivre, par exemple de l'aspartate ou du glutamate de cuivre, suivie de l'application d'une composition comprenant une résine filmogène et un composé à base d'yttrium. Ce traitement avec un composé à base de cuivre est décrit comme améliorant la résistance à la corrosion de la tôle.

La demande EP 2 458 031 décrit l'application sur une tôle en acier galvanisée Gl, ou galvanisée alliée GA, d'une solution de traitement de conversion comprenant un composé (A) choisi parmi les composés de titane ou de zirconium hydrosolubles et un composé organique (B) qui peut notamment être de la glycine, de l'alanine, de l'asparagine, de l'acide glutamique ou aspartique sous forme neutre ou de sel. Selon cette demande, le composé (A) forme sur la tôle un film de conversion qui améliore la compatibilité de la tôle avec les revêtements appliqués ultérieurement, tels que les peintures cataphorétiques, et sa résistance à la corrosion. Le composé (B) est décrit comme stabilisant le composé (A).

La demande WO 00/15878 décrit un procédé de préparation d'une tôle revêtue d'une couche métallique à base de zinc présentant de bonnes propriétés tribologiques bien adaptées à la mise en forme, notamment par emboutissage par un traitement d'hydroxysulfatation. Le développement de procédés alternatifs permettant d'obtenir des tôles ayant de bonnes propriétés tribologiques est recherché.

Un but de l'invention est de donc de proposer un procédé de préparation d'une tôle en acier revêtue par un revêtement métallique comprenant au moins 40% en poids de zinc qui présente de bonnes propriétés tribologiques bien adaptées à sa mise en forme ultérieure, notamment par emboutissage.

Il est également connu que les procédés de décapage chimique ou électrochimique, de recuit sous certaines conditions atmosphériques, de galvanisation ou encore d'électrozinguage génèrent une absorption d'hydrogène par l'acier. Cet hydrogène crée une fragilisation et peut être éliminé par un traitement thermique de dégazage, qui consiste typiquement en un recuit base à une température de l'ordre de 200°C. Un tel traitement est généralement réalisé à la fin du procédé de préparation de la tôle, typiquement après l'étape d'application d'un film de graisse ou d'huile sur la surface extérieure 15 du revêtement métallique 7

La présente demande propose un procédé de préparation d'une tôle en acier revêtue par un revêtement métallique comprenant au moins 40% en poids de zinc qui conserve avantageusement de bonnes propriétés tribologiques après un traitement thermique de dégazage.

A cet effet, l'invention concerne un procédé selon la revendication 1.

Le procédé peut également comprendre les caractéristiques des revendications 2 à 15, prises isolément ou en combinaison.

L'invention concerne également une tôle selon l'une quelconque des revendications 16 à 18, et les utilisations selon les revendications 19 et 20.

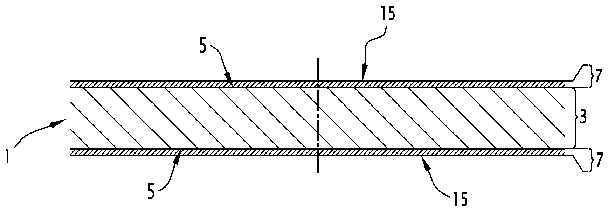

L'invention va à présent être illustrée par des exemples donnés à titre indicatif, et non limitatif, et en référence à la figure annexée, qui est une vue schématique en coupe illustrant la structure d'une tôle 1 obtenue par un procédé selon l'invention.

La tôle 1 de la figure comprend un substrat 3 en acier recouvert sur chacune de ses deux faces 5 par un revêtement métallique 7. On observera que les épaisseurs relatives du substrat 3 et des revêtements 7 le recouvrant n'ont pas été respectées sur la figure afin de faciliter la représentation.

Les revêtements 7 présents sur les deux faces 5 sont analogues et un seul sera décrit en détail par la suite. En variante (non-représentée), seule une des faces 5 présente un revêtement métallique 7.

Le revêtement métallique 7 comprend plus de 40% en poids de zinc, notamment plus de 50% en poids de zinc, de préférence plus de 70% en poids de zinc, plus préférentiellement plus de 90%, de préférence plus de 95%, de préférence plus de 99%. Le complément peut être constitué des éléments métalliques Al, Mg, Si, Fe, Sb, Pb, Ti, Ca, Sr, Mn, Sn, La, Ce, Cr, Ni ou Bi, pris seul ou en combinaison. La mesure de la composition d'un revêtement est généralement réalisée par dissolution chimique du revêtement. Le résultat donné correspond à une teneur moyenne dans l'ensemble de la couche.

Le revêtement métallique 7 peut comprendre plusieurs couches successives de compositions différentes, chacune de ces couches comprenant plus de 40% en poids de zinc (ou plus, comme défini ci-dessus). Le revêtement métallique 7, ou l'une de ses couches constitutives, peut également présenter un gradient de concentration en un élément métallique donné. Lorsque le revêtement métallique 7, ou l'une de ses couches constitutives, présente un gradient de concentration en zinc, la proportion moyenne en zinc dans le revêtement métallique 7, ou dans cette couche constitutive, est de plus de 40% en poids de zinc (ou plus, comme défini ci-dessus).

Pour réaliser la tôle 1, on peut par exemple procéder comme suit.

Le procédé peut comprendre une étape préalable de préparation du substrat 3 en acier présentant deux faces 5, dont au moins l'une est revêtue par un revêtement métallique 7 comprenant au moins 40% en poids de zinc. On utilise un substrat 3 en acier obtenu par exemple par laminage à chaud puis à froid. Le revêtement métallique 7 comprenant plus de 40% en poids de zinc peut être déposé sur le substrat 3 par toute méthode de dépôt connue, notamment par électrozingage, dépôt en phase vapeur (« physical vapor deposition » PVD en anglais), dépôt par jet de vapeur sonique (« Jet Vapor Déposition » JVD en anglais) ou galvanisation à chaud au trempé.

Selon une première alternative, le substrat 3 en acier présentant deux faces 5, dont au moins l'une est revêtue par un revêtement métallique 7 comprenant au moins 40% en poids de zinc est obtenu par électrozingage du substrat 3 en acier. L'application du revêtement peut avoir lieu sur une face (la tôle 1 ne comprend alors qu'un revêtement métallique 7), ou sur deux faces (la tôle 1 comprend alors deux revêtements métalliques 7).

Selon une deuxième alternative, le substrat 3 en acier présentant deux faces 5, dont au moins l'une est revêtue par un revêtement métallique 7 comprenant au moins 40% en poids de zinc est obtenu par galvanisation à chaud du substrat 3 en acier.

Généralement, le substrat 3 est alors sous forme d'une bande que l'on fait défiler dans un bain pour déposer le revêtement métallique 7 par trempé à chaud. La composition du bain varie selon que la tôle 1 désirée est une tôle en acier galvanisée Gl (« galvanized steel sheet » en anglais), GA (galvanisé allié ou « galvannealed steel sheet » en anglais) ou une tôle revêtue par un alliage de zinc et de magnésium, un alliage de zinc et d'aluminium ou un alliage de zinc, de magnésium et d'aluminium. Le bain peut également contenir jusqu'à 0,3% en poids d'éléments optionnels additionnels tels que Si, Sb, Pb, Ti, Ca, Mn, Sn, La, Ce, Cr, Ni ou Bi. Ces différents éléments additionnels peuvent notamment permettre d'améliorer la ductilité ou l'adhésion du revêtement métallique 7 sur le substrat 3. L'homme du métier, qui connaît leurs effets sur les caractéristiques du revêtement métallique 7, saura les employer en fonction du but complémentaire recherché. Le bain peut enfin contenir des éléments résiduels provenant des lingots d'alimentation, ou résultant du passage du substrat 3 dans le bain, source d'impuretés inévitables dans le revêtement métallique 7.

Dans un mode de réalisation, le substrat 3 en acier présentant deux faces 5, dont au moins l'une est revêtue par un revêtement métallique 7 comprenant au moins 40% en poids de zinc, est une tôle en acier galvanisée Gl. Le revêtement métallique 7 est alors un revêtement de zinc Gl. Un tel revêtement comprend plus de 99% en poids de zinc.

Dans un autre mode de réalisation, le substrat 3 en acier présentant deux faces 5, dont au moins l'une est revêtue par un revêtement métallique 7 comprenant au moins 40% en poids de zinc est une tôle en acier galvanisée GA. Le revêtement métallique 7 est alors un revêtement de zinc GA. Une tôle en acier galvanisée GA est obtenue par recuit (« annealing » en anglais) d'une tôle en acier galvanisée Gl. Dans ce cas, le procédé comprend donc une étape de galvanisation à chaud du substrat 3 en acier, puis une étape de recuit. Le recuit provoque la diffusion du fer du substrat 3 en acier dans le revêtement métallique 7. Le revêtement métallique 7 d'une tôle GA comprend typiquement de 10% à 15% en poids de fer.

Dans un autre mode de réalisation, le revêtement métallique 7 est un alliage de zinc et d'aluminium. Le revêtement métallique 7 peut par exemple comprendre 55% en poids d'aluminium, 43,5% en poids de zinc et 1,5% en poids de silicium, comme l'Aluzinc® vendu par ArcelorMittal.

Dans un autre mode de réalisation, le revêtement métallique 7 est un alliage de zinc et de magnésium, comprenant de préférence plus de 70% en poids de zinc. Les revêtements métalliques comprenant du zinc et du magnésium seront globalement désignés ici sous le terme de revêtements zinc-magnésium ou ZnMg. L'ajout de magnésium au revêtement métallique 7 augmente nettement la résistance à la corrosion de ces revêtements, ce qui peut permettre de réduire leur épaisseur ou d'augmenter la garantie de protection contre la corrosion dans le temps.

Le revêtement métallique 7 peut notamment être un alliage de zinc, de magnésium et d'aluminium, comprenant de préférence plus de 70% en poids de zinc. Les revêtements métalliques comprenant du zinc, du magnésium et de l'aluminium seront globalement désignés ici sous le terme de revêtements zinc- aluminium- magnésium ou ZnAIMg. L'ajout d'aluminium (typiquement de l'ordre de 0,1% en poids) à un revêtement à base de zinc et de magnésium permet également d'améliorer la résistance à la corrosion, et rend la tôle revêtue plus facile à être mise en forme. Ainsi, les revêtements métalliques comprenant essentiellement du zinc sont à présent concurrencés par les revêtements comprenant du zinc, du magnésium et éventuellement de l'aluminium.

Typiquement, le revêtement métallique 7 de type ZnMg ou ZnAIMg comprend entre 0,1 et 10% en poids, typiquement entre 0,3 et 10% en poids, notamment entre 0,3 et 4% en poids de magnésium. En dessous de 0,1% en poids de Mg, la tôle revêtue résiste moins bien à la corrosion et au-delà de 10% en poids de Mg, le revêtement ZnMg ou ZnAIMg s'oxyde trop et ne peut être utilisé.

Au sens de la présente demande, lorsqu'une plage de chiffre est décrite comme étant entre une borne basse et une borne haute, il est sous-entendu que ces bornes sont incluses. Par exemple un revêtement comprenant 0,1% ou 10% en poids de magnésium est inclut lorsque l'expression « Le revêtement métallique 7 comprend entre 0,1 et 10% en poids de magnésium » est utilisée.

Le revêtement métallique 7 de type ZnAIMg comprend de l'aluminium, typiquement entre 0,5 et 11% en poids, notamment entre 0,7 et 6% en poids, de préférence entre 1 et 6% en poids d'aluminium. Typiquement, le rapport massique entre le magnésium et l'aluminium dans le revêtement métallique 7 de type ZnAIMg est strictement inférieur ou égal à 1, de préférence strictement inférieur à 1, et de préférence encore strictement inférieur à 0,9.

L'impureté inévitable la plus courante présente dans le revêtement métallique 7 et résultant du passage du substrat dans le bain est le fer qui peut être présent à une teneur allant jusqu'à 3% en poids, généralement inférieure ou égale à 0,4% en poids, typiquement comprise entre 0,1 et 0,4% en poids par rapport au revêtement métallique 7.

Les impuretés inévitables provenant des lingots d'alimentation, pour les bains ZnAIMg, sont généralement le plomb (Pb), présent à une teneur inférieure à 0,01% en poids par rapport au revêtement métallique 7, le Cadmium (Cd), présent à une teneur inférieure à 0,005% en poids par rapport au revêtement métallique 7et l'étain (Sn), présent à une teneur inférieure à 0,001% en poids par rapport au revêtement métallique 7.

Des éléments additionnels choisis parmi Si, Sb, Pb, Ti, Ca, Mn, Sn, La, Ce, Cr, Ni ou Bi peuvent être présents dans le revêtement métallique 7. La teneur en poids de chaque élément additionnel est généralement inférieure à 0,3%.

Le revêtement métallique 7 a généralement une épaisseur inférieure ou égale à 25 µm et vise de manière classique à protéger le substrat 3 en acier contre la corrosion.

Après dépôt du revêtement métallique 7, le substrat 3 est par exemple essoré au moyen de buses projetant un gaz de part et d'autre du substrat 3.

On laisse ensuite refroidir le revêtement métallique 7 de façon contrôlée pour qu'il se solidifie. Le refroidissement contrôlé du revêtement métallique 7 est assuré à une vitesse de préférence supérieure ou égale à 15°C/s ou encore supérieure à 20°C/s entre le début de la solidification (c'est-à-dire lorsque le revêtement métallique 7 tombe juste sous la température du liquidus) et la fin de solidification (c'est-à-dire lorsque le revêtement métallique 7 atteint la température du solidus).

En variante, l'essorage peut être adapté pour enlever le revêtement métallique 7 déposé sur une face 5 de sorte qu'une seule des faces 5 de la tôle 1 ne soit en définitive revêtue par un revêtement métallique 7.

La bande ainsi traitée peut ensuite être soumise à une étape dite de skin-pass qui permet de l'écrouir et lui conférer une rugosité facilitant sa mise en forme ultérieure.

La surface extérieure 15 du revêtement métallique 7 est soumise à une étape de traitement de surface qui consiste à leur appliquer une solution aqueuse comprenant un aminoacide choisi parmi l'alanine, l'arginine, l'acide aspartique, l'acide glutamique, la cystéine, la glutamine, la glycine, la lysine, la méthionine, la proline, la thréonine, et un mélange de ceux-ci. Chaque aminoacide peut être sous forme neutre ou de sel. Au sens de la demande, un aminoacide est un des 22 aminoacides protéinogènes (isomère L) ou un de leurs isomères, notamment leurs isomères D. L'aminoacide est de préférence un aminoacide L pour des raisons de coût.

L'invention repose sur la découverte inattendue que l'application sur la surface extérieure 15 du revêtement métallique 7 d'une solution aqueuse comprenant un aminoacide de la liste définie ci-dessus permet d'améliorer les propriétés tribologiques de la tôle obtenue, ce qui facilite sa mise en forme ultérieure, notamment par emboutissage. Cette amélioration n'est pas observée quel que soit l'aminoacide utilisé. Par exemple, les propriétés tribologiques n'ont pas été améliorées en appliquant de la valine ou de la sérine sur une tôle revêtue par un revêtement métallique 7 comprenant au moins 40% en poids de zinc. Aucune théorie n'a pour l'instant été mise en avant pour expliquer pourquoi certains aminoacides permettent d'améliorer les propriétés tribologiques et pas d'autres.

La solution aqueuse appliquée peut comprendre un aminoacide choisi parmi l'alanine, l'acide aspartique, l'acide glutamique, la cystéine, la glutamine, la glycine, la méthionine, la proline, la thréonine, et un mélange de ceux-ci, chaque aminoacide étant sous forme neutre ou de sel.

La solution aqueuse appliquée peut comprendre un aminoacide choisi parmi l'alanine, l'acide aspartique, l'acide glutamique, la glutamine, la glycine, la méthionine, la proline, la thréonine, et un mélange de ceux-ci, chaque aminoacide étant sous forme neutre ou de sel.

La solution aqueuse appliquée peut notamment comprendre un aminoacide choisi parmi l'alanine, l'arginine, l'acide aspartique, l'acide glutamique, la cystéine, la glycine, la lysine, la méthionine, la proline, la thréonine, et un mélange de ceux-ci, chaque aminoacide étant sous forme neutre ou de sel.

La solution aqueuse appliquée peut comprendre un aminoacide choisi parmi l'alanine, l'arginine, l'acide aspartique, l'acide glutamique, la glycine, la lysine, la méthionine, la proline, la thréonine, et un mélange de ceux-ci, chaque aminoacide étant sous forme neutre ou de sel.

La solution aqueuse appliquée peut typiquement comprendre un aminoacide choisi parmi l'alanine, l'acide aspartique, l'acide glutamique, la cystéine, la glycine, la méthionine, la proline, la thréonine, et un mélange de ceux-ci, chaque aminoacide étant sous forme neutre ou de sel.

La solution aqueuse appliquée peut typiquement comprendre un aminoacide choisi parmi l'alanine, l'acide aspartique, l'acide glutamique, la glycine, la méthionine, la proline, la thréonine, et un mélange de ceux-ci, chaque aminoacide étant sous forme neutre ou de sel.

De préférence, dans la première alternative dans laquelle la tôle 1 est une tôle en acier électrozinguée, l'aminoacide de la solution aqueuse appliquée est choisi parmi l'acide aspartique, la cystéine, la méthionine, la proline et la thréonine, et un mélange de ceux-ci, chaque aminoacide étant sous forme neutre ou de sel, en particulier parmi la cystéine, la méthionine, la proline et la thréonine, et un mélange de ceux-ci, chaque aminoacide étant sous forme neutre ou de sel, par exemple parmi la méthionine, la proline et la thréonine, et un mélange de ceux-ci, chaque aminoacide étant sous forme neutre ou de sel.

De préférence, dans la seconde alternative dans laquelle la tôle 1 est une tôle obtenue par galvanisation à chaud du substrat 3 en acier, l'aminoacide de la solution aqueuse appliquée est choisi parmi l'alanine, l'arginine, l'acide glutamique, la cystéine, la glycine, la lysine, la méthionine, la proline, la thréonine, et un mélange de ceux-ci, chaque aminoacide étant sous forme neutre ou de sel. Typiquement, l'aminoacide de la solution aqueuse appliquée est choisi parmi l'alanine, l'acide glutamique, la cystéine, la glycine, la méthionine, la proline, la thréonine, et un mélange de ceux-ci, chaque aminoacide étant sous forme neutre ou de sel, par exemple parmi l'alanine, l'acide glutamique, la glycine, la méthionine, la proline, la thréonine, et un mélange de ceux-ci, chaque aminoacide étant sous forme neutre ou de sel.

De préférence, dans la troisième alternative dans laquelle la tôle 1 est indifféremment une tôle en acier électrozinguée ou une tôle obtenue par galvanisation à chaud du substrat 3 en acier, l'aminoacide de la solution aqueuse appliquée est choisi parmi la cystéine, la méthionine, la proline et la thréonine et un mélange de ceux-ci, chaque aminoacide étant sous forme neutre ou de sel, par exemple parmi la méthionine, la proline et la thréonine et un mélange de ceux-ci, chaque aminoacide étant sous forme neutre ou de sel.

L'aminoacide est notamment choisi parmi la proline sous forme neutre ou de sel, la cystéine sous forme neutre ou de sel, et un mélange de celles-ci. La proline est particulièrement efficace pour améliorer les propriétés tribologiques de la tôle 1. La cystéine permet avantageusement de doser la quantité d'aminoacide déposé en surface grâce à sa fonction thiol, par exemple par spectrométrie de fluorescence X (SFX).

De préférence, l'aminoacide est choisi parmi la proline sous forme neutre ou de sel, la thréonine sous forme neutre ou de sel, et un mélange de celles-ci. La proline et la thréonine permettent en effet non seulement d'améliorer les propriétés tribologiques de la surface de la tôle, mais aussi d'améliorer la compatibilité de la surface avec un adhésif et d'améliorer la résistance à la corrosion de la tôle.

L'amélioration de la résistance à la corrosion peut par exemple être mise en évidence en faisant des tests selon les normes ISO 6270-2 de 2005 et/ou VDA 230-213 de 2008, et l'amélioration de la compatibilité de la surface de la tôle avec un adhésif peut par exemple être mise en évidence en effectuant des tests de traction sur des échantillons de tôles assemblés par l'intermédiaire d'un adhésif et éventuellement vieillies, jusqu'à rupture de l'assemblage et en mesurant la contrainte maximale de traction et la nature de la rupture.

Il est particulièrement surprenant que la thréonine et/ou la proline permettent d'améliorer ces trois propriétés à la fois. Dans les conditions testées, les autres aminoacides n'ont pas permis une amélioration de ces trois propriétés sur tout type de revêtement métallique comprenant au moins 40% en poids de zinc (au mieux, les autres aminoacides ont permis d'observer une amélioration de deux de ces propriétés, mais pas des trois).

La solution aqueuse appliquée comprend généralement de 1 à 200 g/L, notamment de 5 g/L à 150 g/L, typiquement de 5 g/L à 100 g/L, par exemple de 10 à 50 g/L d'aminoacide sous forme neutre ou de sel ou de mélange d'aminoacide sous forme neutres ou de sels. L'amélioration la plus importante des propriétés tribologiques du revêtement métallique 7 de la tôle 1 a été observée en utilisant une solution aqueuse comprenant de 5 g/L à 100 g/L, en particulier de 10 à 50 g/L d'aminoacide ou de mélange d'aminoacide. Lorsque l'aminoacide est la thréonine, l'amélioration la plus importante des propriétés tribologiques de la tôle 1 a été observée en utilisant une solution aqueuse comprenant de 5 g/L à 50 g/L, en particulier de 10 à 50 g/L de thréonine. Lorsque l'aminoacide est la proline et que le revêtement métallique (7) a été obtenu par galvanisation à chaud du substrat 3 en acier, l'amélioration la plus importante des propriétés tribologiques de la tôle 1 a été observée en utilisant une solution aqueuse comprenant de 5 g/L à 100 g/L, en particulier de 10 à 50 g/L de proline.

La solution aqueuse appliquée comprend généralement de 10 à 1750 mmol/L, notamment de 40 mmol/L à 1300 mmol/L, typiquement de 40 mmol/L à 870 mmol/L, par exemple de 90 à 430 mmol /L d'aminoacide sous forme neutre ou de sel ou de mélange d'aminoacide sous forme neutres ou de sels. L'amélioration la plus importante des propriétés tribologiques du revêtement métallique 7 de la tôle 1 a été observée en utilisant une solution aqueuse comprenant de 40 mmol/L à 870 mmol/L, en particulier de 90 à 430 mmol/L d'aminoacide ou de mélange d'aminoacide. Lorsque l'aminoacide est la thréonine ou un de ses sels, l'amélioration la plus importante des propriétés tribologiques de la tôle 1 a été observée en utilisant une solution aqueuse comprenant de 40 mmol/L à 430 mmol/L, en particulier de 90 mmol/L à 430 mmol/L de thréonine ou d'un de ses sels. Lorsque l'aminoacide est la proline ou un de ses sels et que le revêtement métallique (7) a été obtenu par galvanisation à chaud du substrat 3 en acier, l'amélioration la plus importante des propriétés tribologiques de la tôle 1 a été observée en utilisant une solution aqueuse comprenant de 40 mmol/L à 870 mmol/L, en particulier de 90 mmol/L à 430 mmol/L de proline ou d'un de ses sels.

Bien entendu, les proportions massiques et molaires de l'aminoacide (ou de chacun des aminoacides quand un mélange d'aminoacides est utilisé) dans la solution aqueuse ne peuvent être supérieures aux proportions correspondant à la limite de solubilité de l'aminoacide à la température à laquelle la solution aqueuse est appliquée.

Généralement, le pourcentage massique en extrait sec de l'aminoacide sous forme neutre ou de sel ou du mélange d'aminoacides sous forme neutres ou de sels dans la solution aqueuse est supérieur ou égal à 50%, notamment supérieur ou égal à 65%, typiquement supérieur ou égal à 75%, notamment supérieur ou égal à 90%, de préférence supérieur ou égal à 95%. De même, généralement, le pourcentage molaire en extrait sec de l'aminoacide sous forme neutre ou de sel dans la solution aqueuse est supérieur ou égal à 50%, typiquement supérieur ou égal à 75%, notamment supérieur ou égal à 90%, de préférence supérieur ou égal à 95%.

La solution aqueuse peut comprendre du sulfate de zinc et/ou du sulfate de fer. La proportion en sulfate de zinc dans la solution aqueuse est généralement inférieure à 80 g/L, de préférence inférieure à 40 g/L. De préférence, la solution aqueuse est exempte de sulfate de zinc et de sulfate de fer.

Généralement, la solution aqueuse comprenant un aminoacide comprend moins de 10g/L, typiquement moins de 1g/L, généralement moins de 0,1 g/L, notamment moins de 0,05 g/L, par exemple moins de 0,01 g/L d'ions zinc. De préférence, la solution aqueuse est exempte d'ion zinc (outre les traces inévitables, qui pourraient par exemple provenir de la pollution, par le substrat, du bain de la solution aqueuse).

La solution aqueuse comprenant un aminoacide comprend généralement moins de 0,005 g/L d'ions fer. La solution aqueuse comprenant un aminoacide comprend généralement peu d'ions métalliques autres que le potassium, le sodium, le calcium et le zinc, typiquement moins de 0,1 g/L, notamment moins de 0,05 g/L, par exemple moins de 0,01 g/L, de préférence moins de 0,005 g/L d'ions métalliques autres que le potassium, le sodium, le calcium et le zinc. Typiquement, la solution aqueuse est exempte d'ions métalliques autres que le zinc, le sodium, le calcium et le potassium. La solution aqueuse comprenant un aminoacide comprend généralement peu d'ions métalliques autres que le zinc, typiquement moins de 0,1 g/L, notamment moins de 0,05 g/L, par exemple moins de 0,01 g/L, de préférence moins de 0,005 g/L d'ions métalliques autres que le zinc. Typiquement, la solution aqueuse est exempte d'ions métalliques autres que le zinc. En particulier, la solution aqueuse comprenant un aminoacide comprend généralement peu d'ions cobalt et/ou nickel, typiquement moins de 0,1 g/L, notamment moins de 0,05 g/L, par exemple moins de 0,01g/L d'ions cobalt et/ou nickel. De préférence, la solution aqueuse est exempte d'ions cobalt et/ou exempte d'ions nickel et/ou exempte d'ions cuivre et/ou exempte d'ions chrome. La solution aqueuse est exempte de composé comprenant un métal du groupe IIIB (Sc, Y, La, Ac) ou du groupe IVB (Ti, Zr, Hf, Rf). De préférence, elle est exempte d'ions métalliques (outre les impuretés métalliques inévitables, qui pourraient par exemple provenir de la pollution, par le substrat, du bain de la solution aqueuse).

De façon générale, l'absence d'ions métalliques dans la solution aqueuse permet d'éviter de perturber l'action du principe actif qu'est l'aminoacide ou le mélange d'aminoacides.

De plus, la solution aqueuse comprenant un aminoacide comprend généralement moins de 0,1 g/L, notamment moins de 0,05 g/L, par exemple moins de 0,01 g/L de composés comprenant du chrome VI, ou plus généralement du chrome. Généralement, elle est exempte de composés comprenant du chrome VI, ou plus généralement du chrome.

Par ailleurs, la solution aqueuse est généralement exempte d'agent oxydant.

Par ailleurs, la solution aqueuse est généralement exempte de résine, en particulier de résine organique. Une résine désigne un produit polymère (naturel, artificiel ou synthétique) qui est une matière première pour fabriquer par exemple des matières plastiques, textiles, peintures (liquides ou en poudre), adhésifs, vernis, mousses de polymère. Elle peut être thermoplastique ou thermodurcissable. De manière plus générale, la solution aqueuse est généralement exempte de polymère.

L'absence de résine permet d'obtenir une couche de traitement de faible épaisseur et d'ainsi faciliter son élimination lors du dégraissage précédant la phosphatation et la mise en peinture. Une résine a, dans ces conditions, tendance à laisser des résidus qui perturbent la phosphatation.

Le pH de la solution aqueuse appliquée est généralement compris d'un pH égal au [point isoélectrique de l'aminoacide - 3] à un pH égal au [point isoélectrique de l'aminoacide + 3], notamment d'un pH égal au [point isoélectrique de l'aminoacide - 2] à un pH égal au [point isoélectrique de l'aminoacide + 2], de préférence d'un pH égal au [point isoélectrique de l'aminoacide - 1] à un pH égal au [point isoélectrique de l'aminoacide + 1]. Par exemple, lorsque l'aminoacide est la proline dont le point isoélectrique est de 6,3, le pH de la solution aqueuse est généralement de 3,3 à 9,3, notamment de 4,3 à 8,3, de préférence de 5,3 à 7,3.

Le pH de la solution aqueuse appliquée est généralement compris d'un pH égal au [point isoélectrique de l'aminoacide - 3] à un pH égal au [point isoélectrique de l'aminoacide + 1], de préférence d'un pH égal au [point isoélectrique de l'aminoacide - 3] à un pH égal au [point isoélectrique de l'aminoacide - 1], notamment d'un pH égal au [point isoélectrique de l'aminoacide - 2,5] à un pH égal au [point isoélectrique de l'aminoacide - 1,5], typiquement un pH égal au [point isoélectrique de l'aminoacide - 2]. Par exemple, lorsque l'aminoacide est la proline dont le point isoélectrique est de 6,3, le pH de la solution aqueuse est de préférence de 3,3 à 5,3, notamment de 3,8 à 4,8, typiquement de l'ordre de 4,0, comme 4,3. Un tel pH permet en effet de favoriser la liaison entre l'aminoacide et le revêtement métallique 7. En particulier, un procédé mis en oeuvre avec une solution ayant un tel pH permet d'obtenir une tôle qui conserve ses propriétés tribologiques améliorées, même lorsqu'elle a subi un traitement de lavage/rehuilage. Généralement, une fois que la tôle selon l'invention a été préparée, elle peut être découpée en flan avant sa mise en forme, typiquement par emboutissage. Afin d'éliminer les impuretés déposées sur la tôle issues de cette découpe, un traitement de lavage/rehuilage peut être mis en oeuvre. Celui-ci consiste à appliquer sur les surfaces de la tôle une huile de faible viscosité, puis à brosser, puis à appliquer une huile de viscosité plus importante. Sans vouloir être lié par une théorie particulière, on suppose qu'une solution ayant un tel pH permet d'obtenir l'aminoacide sous forme protonée (NH₃⁺), ce qui favoriserait la liaison entre l'aminoacide et le revêtement métallique 7 et donc le maintien de l'aminoacide à la surface malgré le traitement de lavage/rehuilage. A des pH différents et notamment supérieurs au [point isoélectrique de l'aminoacide - 1], l'amine de l'aminoacide est peu ou pas protonée : les liaisons entre l'aminoacide et le revêtement métallique 7 seraient moins fortes et l'aminoacide aurait plus tendance à se dissoudre dans l'huile utilisée lors du traitement de lavage/rehuilage, conduisant à son élimination au moins partielle, et donc à de moins bonnes propriétés tribologiques de la surface de la tôle ayant subi un tel traitement.

L'homme du métier sait comment adapter le pH de la solution aqueuse, par ajout d'une base s'il souhaite augmenter le pH, ou d'un acide, tel que l'acide phosphorique, s'il souhaite le diminuer.

Au sens de la demande, une base ou un acide est indifféremment sous forme neutre et/ou de sel. Généralement, la proportion en acide est inférieure à 10 g/L, notamment 1 g/L dans la solution. De préférence, l'acide phosphorique est ajouté conjointement sous forme neutre et sous forme de sel (par exemple de sodium, de calcium ou encore de potassium) par exemple en mélange H₃PO₄/NaH₂PO₄. L'acide phosphorique permet avantageusement de doser la quantité de solution aqueuse (et donc d'acide aminé) déposée en surface grâce aux phosphore et/ou sodium, par exemple par spectrométrie de fluorescence X (SFX).

Dans un mode de réalisation, la solution aqueuse consiste en un mélange d'eau, d'aminoacide sous forme neutre ou de sel ou d'un mélange d'aminoacides indépendamment sous formes neutres ou de sels et éventuellement d'une base ou d'un mélange de bases, ou d'un acide ou d'un mélange d'acides. La base ou l'acide sert à adapter le pH de la solution aqueuse. L'aminoacide confère les propriétés tribologiques améliorées. La base ou l'acide permettent de renforcer cet effet. L'ajout d'autres composés n'est pas nécessaire.

Dans le procédé selon l'invention, la solution aqueuse comprenant un aminoacide peut être appliquée à une température comprise entre 20 et 70°C. La durée d'application de la solution aqueuse peut être entre 0,5s et 40s, de préférence entre 2s et 20s.

La solution aqueuse comprenant un aminoacide peut être appliquée par immersion, aspersion ou tout autre système.

L'application de la solution aqueuse sur la surface extérieure 15 du revêtement métallique 7 peut être effectuée par tout moyen, par exemple par immersion, par pulvérisation (« spray » en anglais) ou par enduction au rouleau (« roll coat » en anglais). Cette dernière technique est préférée car elle permet de contrôler plus facilement la quantité de solution aqueuse appliquée tout en assurant une répartition homogène de la solution aqueuse sur la surface. Généralement, l'épaisseur de film humide constitué de la solution aqueuse appliquée sur la surface extérieure 15 du revêtement métallique 7 est de 0,2 à 5 µm, typiquement entre 1 et 3 µm.

Par « application sur la surface extérieure 15 du revêtement métallique 7 d'une solution aqueuse comprenant un aminoacide», on entend que la solution aqueuse comprenant un aminoacide est mise en contact avec la surface extérieure 15 du revêtement métallique 7. Il est donc sous-entendu que la surface extérieure 15 du revêtement métallique 7 n'est pas recouverte d'une couche intermédiaire (un film, un revêtement ou une solution) qui empêcherait la mise en contact de la solution aqueuse comprenant un aminoacide avec la surface extérieure 15 du revêtement métallique 7.

Typiquement, le procédé comprend, après l'étape d'application sur la surface extérieure 15 du revêtement métallique 7 d'une solution aqueuse comprenant un aminoacide, une étape de séchage, qui permet d'obtenir sur la surface extérieure 15 du revêtement métallique 7 une couche comprenant (ou constituée de) un aminoacide (sous forme neutre ou de sel) ou un mélange d'aminoacides (indépendamment sous formes neutres ou de sels). Celle-ci peut être effectuée en soumettant la tôle 1 à une température comprise entre 70 et 120°C, par exemple entre 80 et 100°C, généralement pendant 1 à 30 secondes, notamment 1 à 10 secondes, par exemple 2 s. En particulier, un procédé mis en oeuvre avec une telle étape de pH permet d'obtenir une tôle qui conserve ses propriétés tribologiques améliorées, même lorsqu'elle a subi subir un traitement de lavage/rehuilage.

Le revêtement métallique 7 de la tôle 1 obtenue est alors typiquement revêtu par une couche comprenant de 0,1 à 200 mg/m², notamment de 25 à 150 mg/m², en particulier de 50 à 100 mg/m², par exemple de 60 à 70 mg/m² d'aminoacide (sous forme neutre ou de sel) ou d'un mélange d'aminoacides (indépendamment sous formes neutres ou de sels). La quantité d'aminoacide déposé sur la surface extérieure 15 du revêtement métallique 7 peut être déterminée en dosant la quantité d'aminoacide déposé (par exemple par infrarouge), ou bien en dosant la quantité d'aminoacide restant dans la solution aqueuse (par exemple par dosage acidobasique et/ou par conductimétrie), étant donné que la concentration initiale en aminoacide de la solution aqueuse est connue. De plus, lorsque que l'aminoacide ou un des aminoacides est la cystéine, la quantité de cystéine déposée en surface peut être déterminée par spectrométrie de fluorescence X (SFX).

Généralement, la couche comprenant un aminoacide (sous forme neutre ou de sel) ou un mélange d'aminoacides (indépendamment sous formes neutres ou de sels) qui revêt le revêtement métallique 7 de la tôle 1 obtenue comprend de 50 à 100% en poids, notamment de 75 à 100% en poids, typiquement de 90 à 100% en poids d'aminoacide (sous forme neutre ou de sel) ou de mélange d'aminoacides (indépendamment sous formes neutres ou de sels).

Le procédé peut comprendre (ou être exempt) d'autre(s) étape(s) de traitement de surface que celui consistant à appliquer une solution aqueuse comprenant un aminoacide (par exemple un traitement de surface par oxydation alcaline et/ou un traitement de conversion chimique). Lorsque cette(s) étape(s) de traitement de surface conduit(sent) à la formation d'une couche sur le revêtement métallique 7, cette(ces) autre(s) étape(s) de traitement de surface est(sont) effectuée(s) simultanément ou après l'étape d'application d'une solution aqueuse comprenant un aminoacide sur la surface extérieure 15 du revêtement métallique 7, afin qu'il n'y ait pas de couche intermédiaire entre la surface extérieure 15 du revêtement métallique 7 et la solution aqueuse comprenant un aminoacide. Ces éventuelles étapes de traitement de surface susmentionnées peuvent comprendre d'autres sous-étapes de rinçage, de séchage....

Après avoir appliqué la solution aqueuse comprenant un aminoacide, un film de graisse ou d'huile est généralement appliqué sur la surface extérieure 15 du revêtement métallique 7 revêtue d'une couche comprenant un aminoacide ou d'un mélange d'aminoacides afin de le protéger contre la corrosion.

La bande peut éventuellement être bobinée avant d'être stockée. Typiquement, avant de mettre la pièce en forme, la bande est découpée. Un film de graisse ou d'huile peut alors être de nouveau appliqué sur la surface extérieure 15 du revêtement métallique 7 revêtue d'une couche comprenant un aminoacide ou un mélange d'aminoacides avant la mise en forme.

De préférence, le procédé est exempt d'étape de dégraissage (typiquement réalisée en appliquant une solution aqueuse basique de pH généralement supérieur à 9 sur la surface extérieure 15 du revêtement métallique 7) avant mise en forme. En effet, le traitement par une solution aqueuse basique sur la surface extérieure 15 du revêtement métallique 7 revêtue d'une couche comprenant un aminoacide ou d'un mélange d'aminoacides pourrait conduire à l'élimination partielle ou totale de l'(des) aminoacide(s) qui a(ont) été déposé(s) sur la surface extérieure 15 du revêtement métallique 7, ce que l'on cherche à éviter.

La tôle peut ensuite être mise en forme par tout procédé adapté à la structure et à la forme des pièces à fabriquer, de préférence par emboutissage, tel que par exemple l'emboutissage à froid. La tôle 1 mise en forme correspond alors à une pièce, par exemple une pièce automobile.

Une fois que la tôle 1 a été mise en forme, le procédé peut alors comprendre (ou être exempt d') :
- une étape de dégraissage, typiquement réalisée en appliquant une solution aqueuse basique sur la surface extérieure 15 du revêtement métallique 7, et/ou
- d'autre(s) étape(s) de traitement de surface, par exemple une étape de phosphatation, et/ou
- une étape de cataphorèse.

L'invention concerne également la tôle 1 susceptible d'être obtenue par le procédé. Un telle tôle comprend au moins une partie d'au moins une surface extérieure 15 du revêtement métallique 7 revêtue par une couche comprenant de 0,1 à 200 mg/m², notamment de 25 à 150 mg/m², en particulier de 50 à 100 mg/m², par exemple de 60 à 70 mg/m² d'aminoacide sous forme neutre ou de sel.

L'invention concerne également l'utilisation d'une solution aqueuse comprenant un aminoacide choisi parmi l'alanine, l'arginine, l'acide aspartique, l'acide glutamique, la cystéine, la glutamine, la glycine, la lysine, la méthionine, la proline, la thréonine, et un mélange de ceux-ci, chaque aminoacide étant sous forme neutre ou de sel, la solution aqueuse étant exempte de composé comprenant un métal du groupe IIIB ou du groupe IVB, pour améliorer les propriétés tribologiques d'une surface extérieure 15 d'un revêtement métallique 7 revêtant au moins une face 5 d'un substrat 3 en acier, où le revêtement métallique 7 comprend au moins 40% en poids de zinc. L'amélioration des propriétés tribologiques peut notamment être mis en évidence par la diminution, voire l'élimination de broutage (« stick slip » en anglais), et/ou par la diminution du coefficient de friction (µ) lorsque l'aminoacide tel que défini ci-dessus est appliqué.

Les modes de réalisation préférentiels décrits ci-dessus pour la solution aqueuse, les conditions d'application de la solution aqueuse et le revêtement métallique 7 sont bien sûr applicables.

L'invention concerne également un procédé pour améliorer les propriétés tribologiques d'une surface extérieure 15 d'un revêtement métallique 7 revêtant au moins une face 5 d'un substrat 3 en acier, comprenant au moins les étapes de :
- fourniture d'un substrat 3 en acier présentant deux faces 5, dont au moins l'une est revêtue par un revêtement métallique 7 comprenant au moins 40% en poids de zinc,
- application sur la surface extérieure 15 du revêtement métallique 7 d'une solution aqueuse comprenant un aminoacide choisi parmi l'alanine, l'arginine, l'acide aspartique, l'acide glutamique, la cystéine, la glutamine, la glycine, la lysine, la méthionine, la proline, la thréonine, et un mélange de ceux-ci, chaque aminoacide étant sous forme neutre ou de sel, la solution aqueuse étant exempte de composé comprenant un métal du groupe IIIB ou du groupe IVB.

Les modes de réalisation préférentiels décrits ci-dessus pour la solution aqueuse, les conditions d'application de la solution aqueuse, le revêtement métallique 7 et les éventuelles étapes supplémentaires dans le procédé sont bien sûr applicables.

L'invention concerne également l'utilisation d'une solution aqueuse comprenant un aminoacide choisi parmi la proline, la thréonine et un mélange de celles-ci, la proline et la thréonine étant indépendamment sous forme neutre ou de sel, la solution aqueuse étant exempte de composé comprenant un métal du groupe IIIB ou du groupe IVB, pour :
- améliorer la compatibilité, avec un adhésif 13, d'au moins une partie d'une surface extérieure 15 d'un revêtement métallique 7 revêtant au moins une face 5 d'un substrat 3 en acier,
- améliorer la résistance à la corrosion de la surface extérieure 15 du revêtement métallique 7 revêtant au moins une face 5 du substrat 3 en acier, et
- améliorer les propriétés tribologiques de la surface extérieure 15 du revêtement métallique 7 revêtant au moins une face 5 du substrat 3 en acier,
où le revêtement métallique 7 comprend au moins 40% en poids de zinc.

Les modes de réalisation préférentiels décrits ci-dessus pour la solution aqueuse, les conditions d'application de la solution aqueuse et le revêtement métallique 7 sont bien sûr applicables.

L'invention concerne également un procédé pour :
- améliorer la compatibilité, avec un adhésif 13, d'au moins une partie d'une surface extérieure 15 d'un revêtement métallique 7 revêtant au moins une face 5 d'un substrat 3 en acier,
- améliorer la résistance à la corrosion de la surface extérieure 15 du revêtement métallique 7 revêtant au moins une face 5 du substrat 3 en acier, et
- améliorer les propriétés tribologiques de la surface extérieure 15 du revêtement métallique 7 revêtant au moins une face 5 du substrat 3 en acier,
ledit procédé comprenant au moins les étapes de :
- fourniture d'un substrat 3 en acier présentant deux faces 5, dont au moins l'une est revêtue par un revêtement métallique 7 comprenant au moins 40% en poids de zinc,
- application sur la surface extérieure 15 du revêtement métallique 7 d'une solution aqueuse comprenant un aminoacide choisi parmi la proline, la thréonine et un mélange de celles-ci, la proline et la thréonine étant indépendamment sous forme neutre ou de sel, la solution aqueuse étant exempte de composé comprenant un métal du groupe IIIB ou du groupe IVB.

Les modes de réalisation préférentiels décrits ci-dessus pour la solution aqueuse, les conditions d'application de la solution aqueuse, le revêtement métallique 7 et les éventuelles étapes supplémentaires dans le procédé sont bien sûr applicables.

### Exemple 1 : Tests de mesure du coefficient de frottement (µ) en fonction de la pression de contact (MPa)

Afin d'illustrer l'invention, des tests de mesure du coefficient de frottement (µ) en fonction de la pression de contact (MPa) ont été réalisés et sont décrits à titre d'exemples non limitatifs.

Des échantillons de tôles 1 en acier recouvertes d'un revêtement métallique 7 comprenant environ 99% de zinc (tôle en acier Gl qualité DX56D, épaisseur 0,7 mm), des échantillons de tôles 1 en acier électrozinguées dont le revêtement comprenait 100% de zinc (tôle en acier EG qualité DC06, épaisseur 0,8 mm), des échantillons de tôles 1 en acier Fortiform® électrozinguées dont le revêtement comprenait 100% de zinc (7,5 µm sur les deux faces) ou bien des échantillons de tôles 1 en acier revêtues par dépôt par jet de vapeur sonique (Zn JVD) dont le revêtement comprenait 100% de zinc (7,5 µm sur les deux faces) ont été utilisés.

On a découpé dans ces tôles en acier des échantillons ayant des dimensions de 450 mm x35 mm × épaisseur (0,7 mm pour Gl et 0,8 mm pour EG). Les échantillons ont été immergés pour une durée d'immersion de 20 s à une température de 50°C dans une solution aqueuse d'aminoacide dont le pH avait été éventuellement ajusté par ajout de H₃PO₄. De l'huile Fuchs® 3802-39S (en une quantité de 3 g/m²), Fuchs® 4107S (à refus) ou QUAKER 6130 (à refus) a été appliquée sur une face des échantillons.

On a alors mesuré le coefficient de frottement (µ) en fonction de la pression de contact (MPa) en faisant varier la pression de contact de 0 à 80 MPa :
- sur l'échantillon de la tôle selon l'invention ainsi préparé, et
- sur un échantillon de tôle revêtue non traitée par un aminoacide (témoin).

Plusieurs phases de tests ont été effectuées (phases A, B, et C dans le tableau 1 ci-dessous).

Comme illustré par le tableau 1 ci-dessous, on a observé que l'application d'une solution comprenant un aminoacide tel que défini ci-dessus permet :
- de réduire le coefficient de frottement par rapport à une tôle revêtue non traitée par une telle solution (témoin), et/ou
- d'éviter un frottement pas à-coups ou broutage (« stick slip » en anglais), alors qu'à certaines pressions, un broutage est observé pour une tôle revêtue non traitée par une telle solution (témoin),
- de conserver les propriétés tribologiques de la surface extérieure, même après traitement thermique de dégazage.

Ces effets avantageux n'ont pas été observés pour un échantillon de tôle revêtue traitée par de la valine pour lequel un frottement pas à-coups a été observé à 42MPa.

Les autres propriétés des tôles 1 obtenues par le procédé selon l'invention (propriétés mécaniques, compatibilité avec une(des) étape(s) ultérieure(s) de cataphorèse et/ou phosphatation et/ou mise en peinture) n'ont pas été dégradées.

**Tableau 1 : Propriétés tribologiques (Observation d'un broutage et coefficient de friction (µ) en fonction de la pression exercée) pour les échantillons de tôles testés.**

| Tôle | Huile | | Solution aqueuse appliquée | | | Pression (MPa) à laquelle un broutage est observé | Coefficient de friction (µ) | | |
|---|---|---|---|---|---|---|---|---|---|
| | | | Aminoacide (nature) | Concentration en aminoacide (g/L) | pH de la solution aqueuse | | à 40 MPa | à 60 MPa | à 80 MPa |
| Gl | | A | Aucun(témoin) | NA | NA | 21 | 0,180 | 0,190 | 0,200 |
| | | | Alanine | 20 | 6,0 | NA | 0,125 | 0,155 | 0,140 |
| | | | | 50 | 6,0 | NA | 0,105 | 0,095 | 0,090 |
| | | | | 100 | 6,0 | NA | 0,100 | 0,095 | 0,090 |
| | | | | 150 | 6,0 | NA | 0,100 | 0,095 | 0,085 |
| | | | Proline | 50 | 6,3 | NA | 0,145 | 0,160 | 0,150 |
| | | | | 100 | 6,3 | NA | 0,120 | 0,120 | 0,105 |
| | | | | 150 | 6,3 | NA | 0,110 | 0,105 | 0,105 |
| | | | Thréonine | 20 | 5,6 | NA | 0,130 | 0,155 | 0,140 |
| | | | | 50 | 5,6 | NA | 0,110 | 0,110 | 0,100 |
| | | | | 80 | 5,6 | NA | 0,110 | 0,100 | 0,090 |
| | | | | 100 | 5,6 | NA | 0,115 | 0,110 | 0,100 |
| Gl | | B | Aucun(témoin) | NA | NA | 46 | 0,145 | 0,130 | 0,140 |
| | | | Cystéine | 20 | 4,0 | NA | 0,120 | 0,115 | 0,110 |
| | | | | 100 | 4,0 | NA | 0,100 | 0,100 | 0,100 |
| | | | | 150 | 4,0 | NA | 0,100 | 0,100 | 0,100 |
| | | | Glycine | 10 | 4,0 | NA | 0,120 | 0,125 | 0,115 |
| | Fuchs 3802-39S | | | 20 | 4,0 | NA | 0,110 | 0,110 | 0,115 |
| | | | | 100 | 4,0 | NA | 0,100 | 0,095 | 0,090 |
| | | | | 200 | 4,0 | NA | 0,100 | 0,090 | 0,090 |
| | | | Ac.glutamique | 10 | 4,0 | NA | 0,130 | 0,130 | 0,130 |
| | | | Arginine | 10 | 4,0 | NA | 0,120 | 0,140 | 0,135 |
| | | | | 20 | 4,0 | NA | 0,120 | 0,125 | 0,120 |
| | | | | 100 | 4,0 | NA | 0,100 | 0,100 | 0,105 |
| | | | | 150 | 4,0 | NA | 0,105 | 0,105 | 0,105 |
| Gl | | C | Aucun(témoin) | NA | NA | 18 | 0,18 | 0,19 | 0,17 |
| | | | Proline | 80 | 4,0* | NA | 0,13 | 0,13 | 0,12 |
| | | | Proline** | 80 | 4,0* | NA | 0,14 | 0,14 | 0,13 |
| EG DC06 | | | Aucun(témoin) | NA | NA | 43 | 0,170 | 0,200 | 0,190 |
| | | | Acide Aspartique | 5 | naturel | 40 | 0,145 | 0,130 | 0,120 |
| | | | Cystéine | 30 | naturel | NA | 0,140 | 0,130 | 0,120 |
| | | | Methionine | 50 | naturel | NA | 0,120 | 0,130 | 0,150 |
| | | | Proline | 50 | Naturel | NA | 0,120 | 0,120 | 0,120 |
| | | | Thréonine | 20 | naturel | NA | 0,125 | 0,125 | 0,110 |
| EG DC06 | Quaker | | Aucun(témoin) | NA | NA | 18 | 0,19 | 0,16 | 0,14 |
| | | | Proline | 70 | naturel | NA | 0,15 | 0,12 | 0,11 |
| | | | Proline*** | 70 | naturel | NA | 0,15 | 0,12 | 0,11 |
| Fortiform | | | Aucun (témoin) | NA | NA | NA | 0,18 | 0,15 | 0,13 |
| | | | Proline | 70 | naturel | NA | 0,13 | 0,12 | 0,11 |
| Zn JVD | Fuchs® 4107S | A | Aucun(témoin) | NA | NA | NA | 0,25 | 0,22 | 0,18 |
| | | | Proline | 10 | naturel | NA | 0,24 | 0,20 | 0,17 |
| | | | Proline | 20 | naturel | NA | 0,20 | 0,17 | 0,14 |
| | | B | Aucun(témoin) | NA | NA | NA | 0,27 | 0,23 | 0,20 |
| | | | Proline | 10 | naturel | NA | 0,24 | 0,20 | 0,17 |
| | | | Proline | 20 | naturel | NA | 0,20 | 0,17 | 0,14 |
| | | | Proline | 70 | naturel | NA | 0,14 | 0,12 | 0,10 |
| | Quaker | A | Aucun(témoin) | NA | NA | NA | 0,26 | 0,23 | 0,20 |
| | | | Proline | 10 | naturel | NA | 0,25 | 0,20 | 0,18 |
| | | | Proline | 20 | naturel | NA | 0,20 | 0,17 | 0,15 |
| | | B | Aucun(témoin) | NA | NA | NA | 0,26 | 0,23 | 0,20 |
| | | | Proline | 10 | naturel | NA | 0,25 | 0,20 | 0,18 |
| | | | Proline | 20 | naturel | NA | 0,20 | 0,17 | 0,15 |
| | | | Proline | 70 | naturel | NA | 0,14 | 0,12 | 0,10 |

| | | | | | | | | | |
|---|---|---|---|---|---|---|---|---|---|
| EG : substrat électrozingué * : pH ajusté par ajout de H₃PO₄ ** : test après avoir subi un traitement de lavage/rehuilage *** : test après avoir subi un traitement thermique de dégazage (traitement thermique de 24 heures à 210°C en étuve). | | | | | | | | | |

### Exemple 2 : Tests de résistance à la corrosion et tests de traction pour les aminoacides proline et thréonine

### 2.1. Tests de traction

Des tests de traction ont été réalisés et sont décrits à titre d'exemples non limitatifs.

Des échantillons de tôles 1 en acier recouvertes d'un revêtement métallique 7 comprenant environ 99% de zinc (tôle en acier Gl), ou bien des échantillons de tôles 1 en acier électrozinguées comprenant 100% de zinc (tôle en acier EG) ont été utilisées.

Chaque éprouvette 27 a été préparée de la façon suivante. On a découpé des languettes 29 dans la tôle 1 à évaluer. Ces languettes 29 avaient des dimensions de 25 mm × 12,5 mm × 0,2 mm.

Les languettes 29 ont été immergées pour une durée d'immersion de 20 s à une température de 50°C dans une solution aqueuse de proline ou de thréonine dont le pH avait été ajusté par ajout de H₃PO₄, à l'exception des tôles de référence (Ref) n'ayant été soumises à aucun traitement par un aminoacide.

De l'huile Fuchs® 3802-39S a été appliquée sur les languettes 29 en une quantité de 3 g/m².

On a collé deux languettes 29 par un joint 31 d'adhésif BM1496V, BM1440G ou BM1044, qui sont des colles dites « crash » à base d'époxy et commercialisées par la société Dow® Automotive. Ces adhésifs ont été sélectionnés car il s'agit d'adhésifs conduisant classiquement à des ruptures adhésives avant vieillissement et/ou après vieillissement de l'adhésif.

L'éprouvette 27 ainsi constituée a ensuite été portée à 180°C et maintenue à cette température pendant 30 minutes, ce qui permet de cuire la colle.

Des tests de vieillissement ont été effectués avec les éprouvettes 27 dont les languettes 29 ont été collées avec de la colle BM1044. Le vieillissement naturel de l'adhésif est simulé par un vieillissement en cataplasme humide à 70°C pendant 7 ou 14 jours.

L'essai de traction a ensuite été réalisé à une température ambiante de 23°C en imposant une vitesse de traction de 10 mm/min à une languette 29, parallèlement à celle-ci, tandis que l'autre languette 29 de l'éprouvette 27 a été fixée. L'essai a été poursuivi jusqu'à la rupture de l'éprouvette 27.

A l'issue de l'essai, on a noté la contrainte maximale de traction et on a évalué visuellement la nature de la rupture (rupture cohésive, lorsque la rupture a lieu dans l'épaisseur de l'adhésif - rupture adhésive, lorsque la rupture a lieu à une des interfaces entre la tôle et l'adhésif - rupture cohésive superficielle, lorsque la rupture a lieu dans l'adhésif au voisinage d'une interface entre les languettes et la tôle) (sachant que dans l'industrie automobile, on cherche à éviter les ruptures adhésives qui traduisent une mauvaise compatibilité de l'adhésif avec la tôle) .

Dans le tableau 2 sont regroupés les résultats sur tôle Gl.

Dans le tableau 3 sont regroupés les résultats sur tôle électrozinguées (EG).

RCS signifie rupture cohésive superficielle.

Comme illustré par les tableaux 2 et 3 ci-dessous, les tôles 1 qui ont subi un traitement avec une solution aqueuse comprenant de la proline ou de la thréonine favorisent l'apparition de ruptures cohésives superficielles, contrairement aux tôles de référence pour lesquelles plus de ruptures adhésives ont été constatées.

En particulier, sur les tôles Gl (tableau 2):
- avec l'adhésif BM1496V, les faciès de rupture observés sur les essais avec la proline ou la thréonine sont uniquement constitués de rupture cohésive superficielle, contrairement à la référence n'ayant pas subi de traitement (Ref 1) où il est constaté 30% de rupture adhésive.
- Avec l'adhésif BM1440G, les faciès de rupture observés sur les essais avec la proline ou la thréonine sont également uniquement constitués de rupture cohésive superficielle, contrairement à la référence n'ayant pas subi de traitement (Ref 2) où il est constaté 20% de rupture adhésive,
- Avec l'adhésif BM1044, il est observé que l'adhérence de l'adhésif sur les tôles avec la proline ou la thréonine (essais 7A à 7C) vieillit mieux que sur la référence, après 7 et 14 jours de cataplasme humide.

En particulier, sur les tôles électrozinguées (tableau 3), avec l'adhésif BM1496V, les faciès de rupture observés sur les essais 8A à 9B avec la proline ou la thréonine sont majoritairement constitués de rupture cohésive superficielle, contrairement à la référence n'ayant pas subi de traitement (Ref 6) où il est constaté 40% de rupture adhésive.

**Tableau 2 : Contraintes maximales de traction et natures de la rupture pour les éprouvettes à base de tôles Gl testées.**

| **N° Essai** | **Adhésif** | **Acide Aminé** | **Concentration** g/L | **pH** | **Vieillissement** (jours) | **Contrainte Maxi** MPa | **Faciès de rupture** (RCS) |
|---|---|---|---|---|---|---|---|
| 2A | BM1496V | L-Proline | 20 | 4 | NA | 17,8 | 100% |
| 2B | | | 50 | | | 16,8 | 100% |
| 2C | | | 100 | | | 15,1 | 100% |
| 2D | | | 150 | | | 14,4 | 100% |
| 4A | | L-Thréonine | 20 | 4 | NA | 16,8 | 100% |
| 4B | | | 50 | | | 15,9 | 100% |
| 4C | | | 80 | | | 15 | 100% |
| 4D | | | 100 | | | 14,8 | 100% |
| Ref 1 | | NA | NA | NA | NA | 17,9 | 70% |
| 6 | BM1440G | L-Proline | 50 | naturel | NA | 14,5 | 100% |
| Ref 2 | | NA | NA | NA | NA | 14,9 | 80% |
| 7A | BM1044 | L-Proline | 50 | naturel | NA | 10,6 | 100% |
| 7B | | | | | 7 | 11,5 | 100% |
| 7C | | | | | 14 | 11,3 | 90% |
| Ref 3 | | NA | NA | NA | NA | 11,8 | 100% |
| Ref 4 | | | | | 7 | 12 | 80% |
| Ref 5 | | | | | 14 | 11,5 | 60% |

**Tableau 3 : Contraintes maximales de traction et natures de la rupture pour les éprouvettes à base de tôles électrozinguées testées.**

| **N° Essai** | **Adhésif** | **Acide Aminé** | **Concentration** (g/L) | **pH** | **Vieillissement** (jours) | **Contrainte Maxi** (Mpa) | **Faciès de rupture** (RCS) |
|---|---|---|---|---|---|---|---|
| 9A | BM1496V | L-Proline | 20 | naturel | NA | 12,2 | 95% |
| 9B | | | 50 | | | 10 | 100% |
| Ref 6 | | NA | NA | NA | NA | 14,6 | 60% |

### 2.2. Tests de résistance à la corrosion

Afin d'illustrer l'invention, des tests de résistance à la corrosion ont été réalisés selon les normes ISO 6270-2 de 2005 et/ou VDA 230-213 de 2008 sur des tôles 1 en acier recouvertes d'un revêtement métallique 7 comprenant environ 99% de zinc (tôle en acier Gl), ou bien des échantillons de tôles 1 en acier électrozinguées comprenant 100% de zinc (tôle en acier EG), sur lesquelles a été appliqué :
- une solution aqueuse de proline ou de thréonine dont le pH avait été éventuellement ajusté par ajout de H₃PO₄, puis
- de l'huile Fuchs® 3802-39S en une quantité de 3 g/m²,
- et ayant alors été embouties.

Il apparaît que les tôles 1 obtenues par un procédé comprenant l'application d'une solution de proline ou de thréonine présentent une meilleure résistance à la corrosion.

## Revendications

1. Procédé de préparation d'une tôle (1) comprenant au moins les étapes de :
- fourniture d'un substrat (3) en acier dont au moins une face (5) est revêtue par un revêtement métallique (7) comprenant au moins 40% en poids de zinc,
- application sur la surface extérieure (15) du revêtement métallique (7) d'une solution aqueuse comprenant un aminoacide choisi parmi l'alanine, l'arginine, l'acide aspartique, la cystéine, la glutamine, la lysine, la méthionine, la proline, la thréonine, chaque aminoacide étant sous forme neutre ou de sel,
la solution aqueuse étant exempte de composé comprenant un métal du groupe IIIB ou du groupe IVB, et
le pourcentage massique en extrait sec de l'aminoacide sous forme neutre ou de sel ou du mélange d'aminoacides sous forme neutres ou de sels dans la solution aqueuse étant supérieur ou égal à 50%, de préférence supérieur ou égal à 75%.

2. Procédé selon la revendication 1, comprenant une étape préalable de préparation du substrat (3) en acier dont au moins une face (5) est revêtue par un revêtement métallique (7), choisie parmi une galvanisation à chaud, un dépôt par jet de vapeur sonique et un électrozinguage du substrat (3) en acier.

3. Procédé selon l'une quelconque des revendications 1 à 2, dans lequel le revêtement métallique (7) est choisi parmi un revêtement de zinc Gl, un revêtement GA, un alliage de zinc et d'aluminium, un alliage de zinc et de magnésium et un alliage de zinc, de magnésium et d'aluminium, de préférence le revêtement métallique (7) est un alliage de zinc et de magnésium comprenant entre 0,1 et 10% en poids de Mg et éventuellement entre 0,1 et 20% en poids d'AI, le reste du revêtement métallique étant du Zn, les impuretés inévitables et éventuellement un ou plusieurs éléments additionnels choisis parmi Si, Sb, Pb, Ti, Ca, Mn, Sn, La, Ce, Cr, Ni ou Bi.

4. Procédé selon l'une des revendications précédentes, dans lequel l'aminoacide est choisi parmi l'alanine, l'arginine, l'acide aspartique, la cystéine, la lysine, la méthionine, la proline, la thréonine, et un mélange de ceux-ci, chaque aminoacide étant sous forme neutre ou de sel, de préférence la proline sous forme neutre ou de sel.

5. Procédé selon l'une quelconque des revendications 1, 2 ou 4, dans lequel le substrat (3) en acier dont au moins une face (5) est revêtue par un revêtement métallique (7) a été préparé par électrozinguage et l'aminoacide est choisi parmi l'acide aspartique, la cystéine, la méthionine, la proline et la thréonine, et un mélange de ceux-ci, chaque aminoacide étant sous forme neutre ou de sel.

6. Procédé selon l'une quelconque des revendications 1 à 4, dans lequel le substrat (3) en acier dont au moins une face (5) est revêtue par un revêtement métallique (7) a été préparé par galvanisation à chaud et l'aminoacide est choisi parmi l'alanine, l'arginine, la cystéine, la lysine, la méthionine, la proline, la thréonine, et un mélange de ceux-ci, chaque aminoacide étant sous forme neutre ou de sel.

7. Procédé selon l'une des revendications 4 à 6, dans lequel l'aminoacide est choisi parmi la proline sous forme neutre ou de sel, la cystéine sous forme neutre ou de sel, et un mélange de celles-ci, de préférence la proline sous forme neutre ou de sel.

8. Procédé selon l'une quelconque des revendications 1 à 6, dans lequel l'aminoacide est la thréonine sous forme neutre ou de sel ou un mélange de proline et de thréonine, la proline et la thréonine étant sous forme neutre ou de sel.

9. Procédé selon l'une des revendications précédentes, dans lequel la solution aqueuse comprend de 1 à 200 g/L d'aminoacide sous forme neutre ou de sel ou d'un mélange d'aminoacides sous forme neutres ou de sels, ou de 10 à 1750 mmol/L d'aminoacide sous forme neutre ou de sel ou d'un mélange d'aminoacides sous forme neutres ou de sels.

10. Procédé selon l'une des revendications précédentes, dans lequel la solution aqueuse a un pH compris entre un pH égal au [point isoélectrique de l'aminoacide - 3] et un pH égal au [point isoélectrique de l'aminoacide + 1], de préférence compris entre un pH égal au [point isoélectrique de l'aminoacide - 3] et un pH égal au [point isoélectrique de l'aminoacide - 1].

11. Procédé selon l'une des revendications précédentes, dans lequel la solution aqueuse est appliquée à une température comprise entre 20 et 70°C et/ou dans lequel la solution est appliquée pendant une durée comprise entre 0,5s et 40s sur la surface extérieure (15) du revêtement métallique (7).

12. Procédé selon l'une des revendications précédentes, dans lequel la solution est appliquée par enduction au rouleau.

13. Procédé selon l'une des revendications précédentes, comprenant, après l'étape d'application sur la surface extérieure (15) du revêtement métallique (7) d'une solution aqueuse comprenant un aminoacide, une étape de séchage, de préférence
effectuée en soumettant la tôle (1) à une température comprise entre 70 et 120°C pendant 1 à 30 secondes.

14. Procédé selon l'une des revendications précédentes, comprenant, après l'étape d'application sur la surface extérieure (15) du revêtement métallique (7) d'une solution aqueuse comprenant un aminoacide et l'éventuelle étape de séchage, une étape d'application d'un film de graisse ou d'huile sur la surface extérieure (15) du revêtement (7) revêtue d'une couche comprenant un aminoacide ou d'un mélange d'aminoacides.

15. Procédé selon l'une des revendications précédentes, comprenant, après l'étape d'application sur la surface extérieure (15) du revêtement métallique (7) d'une solution aqueuse comprenant un aminoacide, l'éventuelle étape de séchage et l'éventuelle étape d'application d'un film de graisse ou d'huile, une étape de mise en forme de la tôle (1), de préférence par emboutissage.

16. Tôle (1) susceptible d'être obtenue par un procédé selon l'une quelconque des revendications 1 à 14.

17. Tôle (1) selon la revendication précédente, dont au moins une partie d'au moins une surface extérieure (15) du revêtement métallique (7) est revêtue par une couche comprenant de 0,1 à 200 mg/m² d'aminoacide sous forme neutre ou de sel ou d'un mélange d'aminoacides sous forme neutres ou de sels.

18. Tôle (1) selon la revendication 16 ou 17, dont au moins une partie d'au moins une surface extérieure (15) du revêtement métallique (7) est revêtue par une couche comprenant de 50 à 100% en poids d'aminoacide sous forme neutre ou de sel, ou de mélange d'aminoacides sous formes neutres ou de sels.

19. Utilisation d'une solution aqueuse comprenant un aminoacide choisi parmi l'alanine, l'arginine, l'acide aspartique, l'acide glutamique, la cystéine, la glutamine, la glycine, la lysine, la méthionine, la proline, la thréonine, et un mélange de ceux-ci, chaque aminoacide étant sous forme neutre ou de sel, la solution aqueuse étant exempte de composé comprenant un métal du groupe IIIB ou du groupe IVB, pour améliorer les propriétés tribologiques d'une surface extérieure (15) d'un revêtement métallique (7) revêtant au moins une face (5) d'un substrat (3) en acier, où le revêtement métallique (7) comprend au moins 40% en poids de zinc.

20. Utilisation d'une solution aqueuse comprenant un aminoacide choisi parmi la proline, la thréonine et un mélange de celles-ci, la proline et la thréonine étant indépendamment sous forme neutre ou de sel, la solution aqueuse étant exempte de composé comprenant un métal du groupe IIIB ou du groupe IVB, pour :
- améliorer la compatibilité, avec un adhésif 13, d'au moins une partie d'une surface extérieure (15) d'un revêtement métallique (7) revêtant au moins une face (5) d'un substrat (3) en acier,
- améliorer la résistance à la corrosion de la surface extérieure (15) du revêtement métallique (7) revêtant au moins une face (5) du substrat (3) en acier, et
- améliorer les propriétés tribologiques de la surface extérieure (15) du revêtement métallique (7) revêtant au moins une face (5) du substrat (3) en acier,
où le revêtement métallique (7) comprend au moins 40% en poids de zinc.

## Patentansprüche

1. Verfahren zur Herstellung eines Blechs (1), mindestens die Schritte umfassend des:
- Bereitstellens eines Substrats (3) aus Stahl, dessen mindestens eine Seite (5) mit einer Metallbeschichtung (7) bedeckt ist, die mindestens 40 Gew.% Zink enthält,
- Aufbringens einer wässrigen Lösung auf die Außenfläche (15) der Metallbeschichtung (7), die eine Aminosäure enthält, ausgewählt aus Alanin, Arginin, Asparaginsäure, Cystein, Glutamin, Lysin, Methionin, Prolin, Threonin, wobei jede Aminosäure in neutraler Form oder in Form von Salz vorliegt,
wobei die wässrige Lösung frei von einer Verbindung ist, die ein Metall der Gruppe IIIB oder der Gruppe IVB enthält und
der Massenanteil an Trockenmasse der Aminosäure in neutraler Form oder in Form von Salz oder der Mischung von Aminosäuren in neutraler Form oder in Form von Salzen in der wässrigen Lösung größer als oder gleich 50 %, vorzugsweise größer als oder gleich 75 % ist.

2. Verfahren nach Anspruch 1, einen vorherigen Schritt der Aufbereitung des Substrats (3) aus Stahl, dessen mindestens eine Seite (5) mit einer Metallbeschichtung (7) bedeckt ist, umfassend, der ausgewählt ist aus einer Feuerverzinkung, einer Abscheidung durch Ultraschall- Dampfstrahl und einer elektrolytische Verzinkung des Substrats (3) aus Stahl.

3. Verfahren nach einem beliebigen der Ansprüche 1 bis 2, bei dem die Metallbeschichtung (7) ausgewählt ist aus einer Zinkbeschichtung Gl, einer GA Beschichtung, einer Legierung aus Zink und Aluminium, einer Legierung aus Zink und Magnesium und einer Legierung aus Zink, Magnesium und Aluminium, vorzugsweise die Metallbeschichtung (7) eine Legierung aus Zink und Magnesium ist, die zwischen 0,1 und 10 Gew.% Mg und gegebenenfalls zwischen 0,1 und 20 Gew.% AI enthält, wobei der Rest der Metallbeschichtung Zn, unvermeidbare Verunreinigungen und gegebenenfalls ein oder mehrere Zusatzelemente, ausgewählt aus Si, Sb, Pb, Ti, Ca, Mn, Sn, La, Ce, Cr, Ni oder Bi ist.

4. Verfahren nach einem der vorhergehenden Ansprüche, bei dem die Aminosäure ausgewählt ist aus Alanin, Arginin, Asparaginsäure, Cystein, Lysin, Methionin, Prolin, Threonin und einer Mischung aus diesen, wobei jede Aminosäure in neutraler Form oder in Form von Salz, vorzugsweise das Prolin in neutraler Form oder in Form von Salz vorliegt.

5. Verfahren nach einem beliebigen Ansprüche 1, 2 oder 4, bei dem das Substrats (3) aus Stahl, dessen mindestens eine Seite (5) durch eine Metallbeschichtung (7) überdeckt ist, durch elektrolytische Verzinkung hergestellt ist und die Aminosäure ausgewählt ist aus Asparaginsäure, Cystein, Methionin, Prolin, Threonin und einer Mischung aus diesen, wobei jede Aminosäure in neutraler Form oder in Form von Salz vorliegt.

6. Verfahren nach einem beliebigen der Ansprüche 1 bis 4, bei dem das Substrat (3) aus Stahl, dessen mindestens eine Seite (5) mit einer Metallbeschichtung (7) überdeckt ist, durch Feuerverzinkung hergestellt ist und die Aminosäure ausgewählt ist aus Alanin, Arginin, Cystein, Lysin, Methionin, Prolin, Threonin und einer Mischung aus diesen, wobei jede Aminosäure in neutraler Form oder in Form von Salz vorliegt.

7. Verfahren nach einem der Ansprüche 4 bis 6, bei dem die Aminosäure ausgewählt ist aus Prolin in neutraler Form oder in Form von Salz, Cystein in neutraler Form oder in Form von Salz und einer Mischung derselben, vorzugsweise das Prolin in neutraler Form oder in Form von Salz vorliegt.

8. Verfahren nach einem beliebigen der Ansprüche 1 bis 6, bei dem die Aminosäure Threonin in neutraler Form oder in Form von Salz oder eine Mischung aus Prolin und Threonin ist, wobei das Prolin und das Threonin in neutraler Form oder in Form von Salz vorliegen.

9. Verfahren nach einem der vorhergehenden Ansprüche, bei dem die wässrige Lösung von 1 bis 200 g/L Aminosäure in neutraler Form oder in Form von Salz oder eine Mischung aus Aminosäuren in neutraler Form oder in Form von Salzen oder von 10 bis 1750 mmol/L Aminosäure in neutraler Form oder in Form von Salz oder eine Mischung aus Aminosäuren in neutraler Form oder in Form von Salzen enthält.

10. Verfahren nach einem der vorhergehenden Ansprüche, bei dem die wässrige Lösung einen pH Wert zwischen einem pH Wert gleich dem [isoelektrischen Punkt der Aminosäure - 3] und einem pH Wert gleich dem [isoelektrischen Punkt der Aminosäure + 1], vorzugsweise zwischen einem pH Wert gleich dem [isoelektrischen Punkt der Aminosäure - 3] und einem pH Wert gleich dem [isoelektrischen Punkt der Aminosäure - 1] aufweist.

11. Verfahren nach einem der vorhergehenden Ansprüche, bei dem die wässrige Lösung bei einer Temperatur zwischen 20 und 70 °C aufgebracht wird und/oder bei dem die Lösung während einer Dauer zwischen 0,5 Sekunden und 40 Sekunden auf die Außenfläche (15) der Metallbeschichtung (7) aufgebracht wird.

12. Verfahren nach einem der vorhergehenden Ansprüche, bei dem die Lösung durch Walzenbeschichtung aufgebracht wird.

13. Verfahren nach einem der vorhergehenden Ansprüche, das nach dem Schritt des Aufbringens einer wässrigen Lösung, die Aminosäure enthält, auf die Außenfläche (15) der Metallbeschichtung (7) einen Schritt des Trocknens umfasst, der vorzugsweise durch Aussetzen des Blechs (1) einer Temperatur zwischen 70° und 120 °C während 1 bis 30 Sekunden durchgeführt wird.

14. Verfahren nach einem der vorhergehenden Ansprüche, das nach dem Schritt des Aufbringens einer wässrigen Lösung, die Aminosäure enthält, auf die Außenfläche (15) der Metallbeschichtung (7) und dem möglichen Schritt des Trocknens einen Schritt des Aufbringens eines Fett- oder Ölfilms auf die Außenfläche (15) der Beschichtung (7), die mit einer eine Aminosäure oder eine Mischung aus Aminosäuren enthaltenden Schicht bedeckt ist, umfasst.

15. Verfahren nach einem der vorhergehenden Ansprüche, das nach dem Schritt des Aufbringens einer wässrigen Lösung, die Aminosäure enthält, auf die Außenfläche (15) der Metallbeschichtung (7) und dem möglichen Schritt des Trocknens und dem möglichen Schritt des Aufbringens eines Fett- oder Ölfilms einen Schritt der Formgebung des Blechs (1), vorzugsweise durch Tiefziehen umfasst.

16. Blech (1), geeignet durch ein Verfahren nach einem beliebigen der Ansprüche 1 bis 14 erhalten zu werden.

17. Blech (1) nach dem vorhergehenden Anspruch, von dem mindestens ein Teil mindestens einer Außenfläche (15) der Metallbeschichtung (7) mit einer Schicht bedeckt ist, die 0,1 - 200 mg/m² Aminosäure in neutraler Form oder in Form von Salz oder eine Mischung aus Aminosäuren in neutraler Form oder in Form von Salzen enthält.

18. Blech (1) nach Anspruch 16 oder 17, von dem mindestens ein Teil mindestens einer Außenfläche (15) der Metallbeschichtung (7) mit einer Schicht bedeckt ist, die 50 - 100 Gew.% Aminosäure in neutraler Form oder in Form von Salz oder eine Mischung aus Aminosäuren in neutraler Form oder in Form von Salzen enthält.

19. Verwendung einer wässrigen Lösung, die eine Aminosäure enthält, ausgewählt aus Alanin, Arginin, Asparaginsäure, Glutaminsäure, Cystein, Glutamin, Glycin, Lysin, Methionin, Prolin, Threonin und einer Mischung derselben, wobei jede Aminosäure in neutraler Form oder in Form von Salz vorliegt, wobei die wässrige Lösung frei von einer Verbindung ist, die ein Metall der Gruppe IIIB oder der Gruppe IVB enthält, zur Verbesserung der tribologischen Eigenschaften einer Außenfläche (15) einer Metallbeschichtung (7), die mindestens eine Seite (5) eines Substrats (3) aus Stahl bedeckt, wobei die Metallbeschichtung (7) mindestens 40 Gew.% Zink enthält.

20. Verwendung einer wässrigen Lösung, die eine Aminosäure enthält, ausgewählt aus Prolin, Threonin und einer Mischung derselben, wobei das Prolin und das Threonin unabhängig in neutraler Form oder in Form von Salz vorliegen, wobei die wässrige Lösung frei von einer Verbindung ist, die ein Metall der Gruppe IIIB oder der Gruppe IVB enthält, zum
- Verbessern der Kompatibilität mindestens eines Teils einer Außenfläche (15) einer Metallbeschichtung (7), die mindestens eine Seite (5) eines Substrats (3) aus Stahl bedeckt, mit einem Haftmittel 13,
- Verbessern der Korrosionswiderstandsfähigkeit der Außenfläche (15) der Metallbeschichtung (7), die mindestens eine Seite (5) des Substrats (3) aus Stahl bedeckt, und
- Verbessern der tribologischen Eigenschaften der Außenfläche (15) der Metallbeschichtung (7), die mindestens eine Seite (5) des Substrats (3) aus Stahl bedeckt,
wobei die Metallbeschichtung (7) mindestens 40 Gew.% Zink enthält.

## Claims

1. A method for preparing a metal sheet (1) comprising at least the steps of:
- providing a steel substrate (3), at least one face (5) of which is coated with a metal coating (7) comprising at least 40% by weight of zinc,
- applying on the outer surface (15) of the metal coating (7) an aqueous solution comprising an amino acid selected from among alanine, arginine, aspartic acid, cysteine, glutamine, lysine, methionine, proline, threonine, each amino acid being in a neutral or salt form,
the aqueous solution being free of compound comprising a metal from the group IIIB or from the group IVB, and
the mass percentage as dry extract of the amino acid in a neutral or salt form or of the mixture of amino acids in neutral or salt forms in the aqueous solution being greater than or equal to 50%, preferably greater than or equal to 75%.

2. The method according to claim 1, comprising a preliminary step for preparing the steel substrate (3), at least one face (5) of which is coated with a metal coating (7), selected from among hot galvanization, sonic vapor jet deposition and an electro-zinc-plating of the steel substrate (3).

3. The method according to any of claims 1 to 2, wherein the metal coating (7) is selected from a zinc coating Gl, a coating GA, an alloy of zinc and aluminum, an alloy of zinc and of magnesium and an alloy of zinc, magnesium and aluminum, preferably the metal coating (7) is an alloy of zinc and of magnesium comprising between 0.1 and 10% by weight of Mg and optionally between 0.1 and 20% by weight of Al, the remainder of the metal coating being Zn, the inevitable impurities and optionally one or several additional elements selected from among Si, Sb, Pb, Ti, Ca, Mn, Sn, La, Ce, Cr, Ni or Bi.

4. The method according to one of the preceding claims, wherein the amino acid is selected from among alanine, arginine, aspartic acid, cysteine, lysine, methionine, proline, threonine, and a mixture thereof, each amino acid being in a neutral or salt form, preferably proline in a neutral or salt form.

5. The method according to any of claims 1, 2 or 4, wherein the steel substrate (3), at least one face (5) of which is coated with a metal coating (7) has been prepared by electro-zinc-plating and the amino acid is selected from among aspartic acid, cysteine, methionine, proline and threonine, and a mixture thereof, each amino acid being in a neutral or salt form.

6. The method according to any of claims 1 to 4, wherein the steel substrate (3), at least one face (5) of which is coated with a metal coating (7) has been prepared by hot galvanization and the amino acid is selected from among alanine, arginine, cysteine, lysine, methionine, proline, threonine, and a mixture thereof, each amino acid being in a neutral or salt form.

7. The method according to one of claims 4 to 6, wherein the amino acid is selected from among proline in a neutral or salt form, cysteine in a neutral or salt form, and a mixture thereof, preferably proline in a neutral or salt form.

8. The method according to any of claims 1 to 6, wherein the amino acid is threonine in a neutral or salt form or a mixture of proline and threonine, the proline and the threonine being in a neutral or salt form.

9. The method according to one of the preceding claims, wherein the aqueous solution comprises from 1 to 200 g/L of amino acid in a neutral or salt form or a mixture of amino acids in neutral or salt forms or from 10 to 1,750 mmol/L of amino acid in a neutral or salt form or a mixture of amino acids in neutral or salt forms.

10. The method according to one of the preceding claims, wherein the aqueous solution has a pH comprised between a pH equal to [isoelectric point of the amino acid - 3] and a pH equal to the [isoelectric point of the amino acid + 1], preferably comprised between a pH equal to the [isoelectric point of the amino acid - 3] and a pH equal to the [isoelectric point of the amino acid - 1].

11. The method according to one of the preceding claims, wherein the aqueous solution is applied at a temperature comprised between 20 and 70°C and/or wherein the solution is applied for a period comprised between 0.5s and 40s on the outer surface (15) of the metal coating (7).

12. The method according to one of the preceding claims, wherein the solution is applied by roll coating.

13. The method according to one of the preceding claims, comprising, after the step for applying on the outer surface (15) of the metal coating (7) an aqueous solution comprising an amino acid, a drying step, preferably carried out by subjecting the metal sheet (1) to a temperature comprised between 70 and 120°C for 1 to 30 seconds.

14. The method according to one of the preceding claims, comprising, after the step for applying on the outer surface (15) of the metal coating (7) an aqueous solution comprising an amino acid and the optional drying step, a step for applying a grease or oil film on the outer surface (15) of the coating (7) coated with a layer comprising an amino acid or a mixture of amino acids.

15. The method according to one of the preceding claims, comprising, after the step for applying on the outer surface (15) of the metal coating (7) an aqueous solution comprising an amino acid, the optional drying step and the optional step for applying a grease or oil film, a step for shaping the metal sheet (1), preferably by drawing.

16. A metal sheet (1) which may be obtained by a method according to any of claims 1 to 14.

17. The metal sheet (1) according to the preceding claim, wherein at least one portion of at least one outer surface (15) of the metal coating (7) is coated with a layer comprising from 0.1 to 200 mg/m² of amino acid in a neutral or salt form or a mixture of amino acids in neutral or salt forms.

18. The metal sheet (1) according to claim 16 or 17, wherein at least one portion of at least one outer surface (15) of the metal coating (7) is coated with a layer comprising from 50 to 100% by weight of an amino acid in a neutral or salt form, or of a mixture of amino acids in neutral or salt forms.

19. The use of an aqueous solution comprising an amino acid selected from among alanine, arginine, aspartic acid, glutamic acid, cysteine, glutamine, glycine, lysine, methionine, proline, threonine, and a mixture thereof, each amino acid being in a neutral or salt form, the aqueous solution being free of compound comprising a metal from the group IIIB or from the group IVB, for improving the tribological properties of an outer surface (15) of a metal coating (7) coating at least one face (5) of a steel substrate (3), wherein the metal coating (7) comprises at least 40% by weight of zinc.

20. The use of an aqueous solution comprising an amino acid selected from among proline, threonine and a mixture thereof, the proline and the threonine being independently in a neutral or salt form, the aqueous solution being free of compound comprising a metal from the group IIIB or from the group IVB, for:
- improving the compatibility, with an adhesive 13, of at least one portion of an outer surface (15) of a metal coating (7) coating at least one face (5) of a steel substrate (3),
- improving the resistance to corrosion of the outer surface (15) of the metal coating (7) coating at least one face (5) of the steel substrate (3), and
- improving the tribological properties of the outer surface (15) of the metal coating (7) coating at least one face (5) of the steel substrate (3),
wherein the metal coating (7) comprises at least 40% by weight of zinc.
